# EUROPEAN PATENT APPLICATION

(11) **EP 4 794 484 A1**
(43) Date of publication of application: **19.08.2026**
(21) Application number: 24876953.1
(22) Date of filing: 28.08.2024
(51) Int. Cl.: H10F 39/12, H01L 23/12

(54) **SEMICONDUCTOR APPARATUS AND METHOD FOR MANUFACTURING SEMICONDUCTOR APPARATUS**

(30) Priority: 13.10.2023 JP 2023177389
(71) Applicant: Sony Semiconductor Solutions Corporation, Atsugi-shi, Kanagawa 243-0014 (JP)
(72) Inventor: NAKAGAWA, Kanae, Atsugi-shi, Kanagawa 243-0014 (JP); TAKAOKA, Yuji, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/030608
(87) International publication number: WO 2025/079353

(57) **Abstract**

A semiconductor device includes: a semiconductor substrate; a light transmitting layer that is arranged on a side of a first surface of the semiconductor substrate and transmits light having a predetermined wavelength; a rewiring layer at least a part of which is formed on an outer side of the semiconductor substrate in a planar direction; a mold portion that integrates at least the semiconductor substrate and the pre-transmitting layer on a side of a second surface opposite to the first surface; a through hole provided at a position facing an electrode of the semiconductor substrate in the light transmitting layer; and a wiring portion that electrically connects the electrode and the rewiring layer.

## Description

### TECHNICAL FIELD

The present technology relates to a semiconductor device including a semiconductor substrate and a manufacturing method of the semiconductor device.

### BACKGROUND ART

Conventionally, there has been proposed an imaging device including an imaging element, a mold portion formed around the imaging element except for a pixel formation surface of the imaging element, and a rewiring layer provided on the imaging element and the mold portion on the pixel formation surface side (for example, Patent Document 1). With this imaging device, reduction in size and height can be achieved.

### CITATION LIST

### PATENT DOCUMENT

Patent Document 1: Japanese Patent Application Laid-Open No. 2019-216187

### SUMMARY OF THE INVENTION

### PROBLEMS TO BE SOLVED BY THE INVENTION

In the imaging device described above, at the time of generating the rewiring layer, the rewiring layer is formed after the pixel formation surface of the imaging element is film-formed with a protective film. Then, the protective film is removed after the rewiring layer is formed. However, since the protective film is exposed to heating or a chemical solution during formation of the rewiring layer, there is a possibility that the protective film cannot be completely removed in a removal step.

In addition, it is conceivable not to remove the protective film, but in this case, there is a possibility that desired light transmittance and refractive index are not satisfied due to the influence of exposure to heating or the chemical solution in a formation step of the rewiring layer.

The present technology has been made in view of such problems, and an object thereof is to protect a pixel formation surface of a semiconductor substrate at the time of manufacturing while achieving reduction in size and height.

### SOLUTIONS TO PROBLEMS

A semiconductor device according to the present technology includes: a semiconductor substrate; a light transmitting layer that is arranged on a side of a first surface of the semiconductor substrate and transmits light having a predetermined wavelength; a rewiring layer at least a part of which is formed on an outer side of the semiconductor substrate in a planar direction; a mold portion that integrates at least the semiconductor substrate and the light transmitting layer on a side of a second surface opposite to the first surface; a through hole provided at a position facing an electrode of the semiconductor substrate in the light transmitting layer; and a wiring portion that electrically connects the electrode and the rewiring layer.

With this configuration, it is possible to reduce the possibility that a pixel formation surface of the semiconductor substrate is exposed to the outside in the manufacturing step of the semiconductor device.

### BRIEF DESCRIPTION OF DRAWINGS

Fig. 1 is a schematic cross-sectional view illustrating a configuration of an imaging device according to a first embodiment.
Fig. 2 is a diagram illustrating a manufacturing method of the imaging device according to the first embodiment.
Fig. 3 is a diagram illustrating the manufacturing method of the imaging device according to the first embodiment.
Fig. 4 is a diagram illustrating the manufacturing method of the imaging device according to the first embodiment.
Fig. 5 is a diagram illustrating configurations of an imaging element and a light transmitting layer of a first application example according to the first embodiment.
Fig. 6 is a diagram illustrating the manufacturing method of the imaging device of the first application example according to the first embodiment.
Fig. 7 is a diagram illustrating the manufacturing method of the imaging device of the first application example according to the first embodiment.
Fig. 8 is a diagram illustrating a configuration of an imaging device of a second application example according to the first embodiment.
Fig. 9 is a diagram illustrating a configuration of an imaging device of a third application example according to the first embodiment.
Fig. 10 is a cross-sectional schematic view illustrating a configuration of an imaging device according to a second embodiment.
Fig. 11 is a diagram illustrating a manufacturing method of the imaging device according to the second embodiment.
Fig. 12 is a diagram illustrating the manufacturing method of the imaging device according to the second embodiment.
Fig. 13 is a cross-sectional schematic view illustrating a configuration of an imaging device according to a third embodiment.
Fig. 14 is a diagram illustrating a manufacturing method of the imaging device according to the third embodiment.
Fig. 15 is a diagram illustrating the manufacturing method of the imaging device according to the third embodiment.

### MODE FOR CARRYING OUT THE INVENTION

Hereinafter, embodiments will be described in the following order.
<1. First Embodiment>
   [1.1. Configuration of Imaging Device]
   [1.2. Manufacturing Method of Imaging Device]
   [1.3. First Application Example]
   [1.4. Second Application Example]
   [1.5. Third Application Example]
<2. Second Embodiment>
   [2.1. Configuration of Imaging Device]
   [2.2. Manufacturing Method of Imaging Device]
<3. Third Embodiment>
   [3.1. Configuration of Imaging Device]
   [3.2. Manufacturing Method of Imaging Device]
<4. Modifications>
<5. Summary>
<6. Present Technology>

### <1. First Embodiment>

### [1.1. Configuration of Imaging Device]

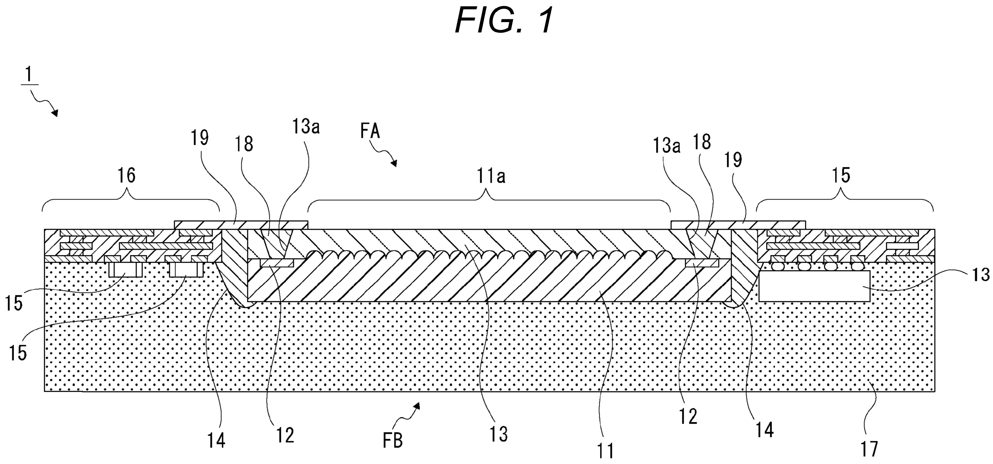

Fig. 1 is a schematic cross-sectional view illustrating a configuration of an imaging device 1 according to a first embodiment.

The imaging device 1 is an example of a semiconductor device, and includes an imaging element 11 in which a plurality of pixels for converting incident light into an electric signal is arranged in, for example, a two-dimensional matrix. Hereinafter, a region in which the plurality of pixels is arranged is referred to as a pixel region 11a. In addition, in the imaging device 1, a surface on which the imaging element 11 is irradiated with incident light is referred to as a front surface FA or a pixel formation surface, and a surface on the opposite side is referred to as a back surface FB.

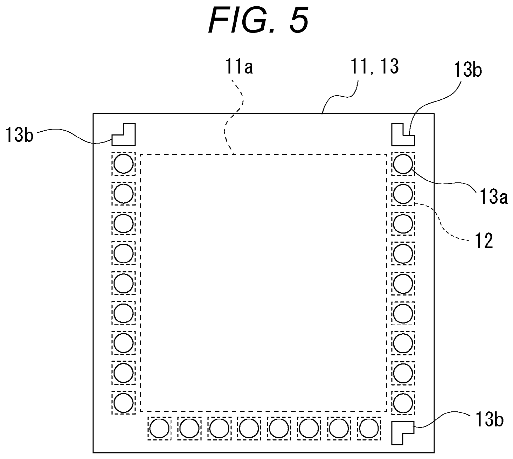

On the front surface FA side of the imaging element 11, an on-chip lens for condensing light to each pixel is formed. In addition, in the imaging element 11, electrode pads 12 are arranged in a region excluding the pixel region 11a on the front surface FA side. Note that a plurality of electrode pads 12 is arranged at equal intervals so as to surround the pixel region 11a (see Fig. 5).

On the front surface FA side of the imaging element 11, a light transmitting layer 13 including a resin material that transmits light having a predetermined wavelength is formed. The light transmitting layer 13 transmits light having a wavelength to be received by the imaging element 11, and transmits visible light, infrared light, and the like, for example. However, the light transmitting layer 13 may transmit light of all wavelengths.

In the light transmitting layer 13, through holes 13a are formed at positions facing the respective electrode pads 12.

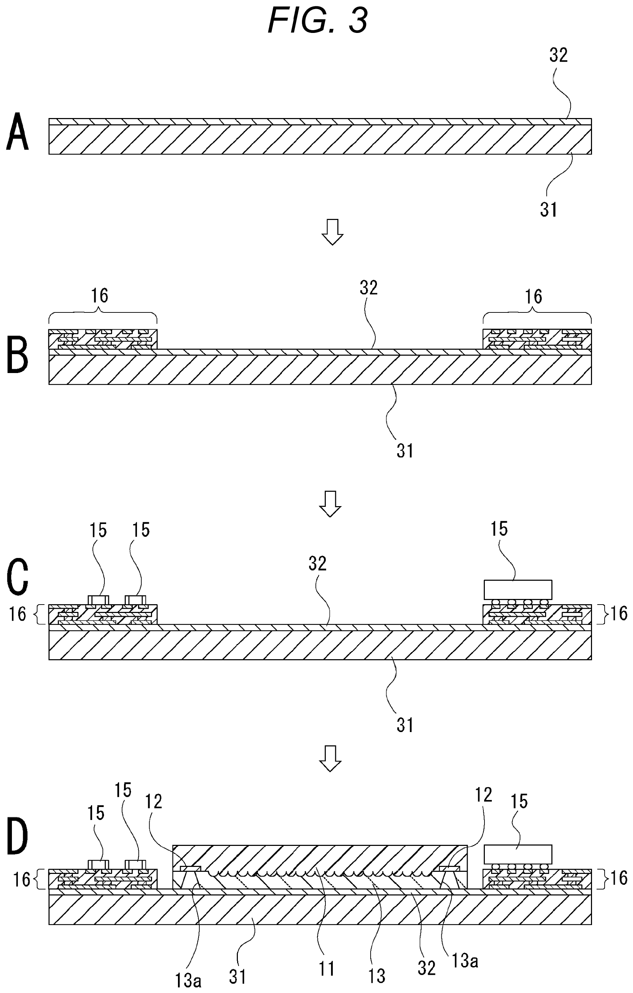

The imaging element 11 and the light transmitting layer 13 are covered with a sealing material 14 so as to surround an outer periphery. The sealing material 14 is, for example, a potting agent, and is provided to fix the imaging element 11 and the light transmitting layer 13 on a peeling layer 32 (see Fig. 3) at the time of manufacturing. Note that the sealing material 14 may not be provided.

In the imaging device 1, an electronic element 15 and a rewiring layer 16 are provided on an outer side of the imaging element 11 and the light transmitting layer 13 in a planar direction.

The electronic element 15 is, for example, a capacitor or the like, and is connected to a wiring layer 16a of the rewiring layer 16 directly or by a solder ball. Note that the electronic element 15 may not be provided in the imaging device 1.

The rewiring layer 16 is provided to electrically connect an external terminal, which has a wider pitch width than the electrode pad 12, and the imaging element 11, and includes the wiring layer 16a and an insulating layer 16b. In the rewiring layer 16, the wiring layers 16a are laminated from the front surface FA side to the back surface FB side, and the insulating layer 16b is arranged between the wiring layers 16a.

In the rewiring layer 16, the predetermined wiring layers 16a are electrically connected to each other in a front-back direction, and the wiring layer 16a provided closest to the front surface FA side is arranged so as to be exposed.

A front surface of the rewiring layer 16 is formed so as to be flush with a front surface of the light transmitting layer 13.

The imaging element 11, the light transmitting layer 13, the sealing material 14, the electronic element 15, and the rewiring layer 16 are integrated by a mold portion 17 including, for example, a resin material.

The wiring layer 16a arranged closest to the front surface FA side in the rewiring layer 16 is electrically connected to the electrode pad 12 via a pillar 18 and a wiring pattern 19.

The pillar 18 is formed so as to fill the through hole 13a, and is electrically connected to the electrode pad 12 on the back surface FB side and is electrically connected to the wiring pattern 19 on the front surface FA side.

The wiring pattern 19 is formed so as to connect a position facing the pillar 18 and a position facing the wiring layer 16a arranged closest to the front surface FA side in the rewiring layer 16, and is electrically connected to the pillar 18 and the wiring layer 16a at a corresponding one of both end portions.

Charges generated by being received by each pixel of the imaging element 11 are transmitted from an internal circuit formed in the imaging element 11 to the rewiring layer 16 via the electrode pad 12, the pillar 18, and the wiring pattern 19, and are output as an electric signal from the rewiring layer 16 via the external terminal.

### [1.2. Manufacturing Method of Imaging Device]

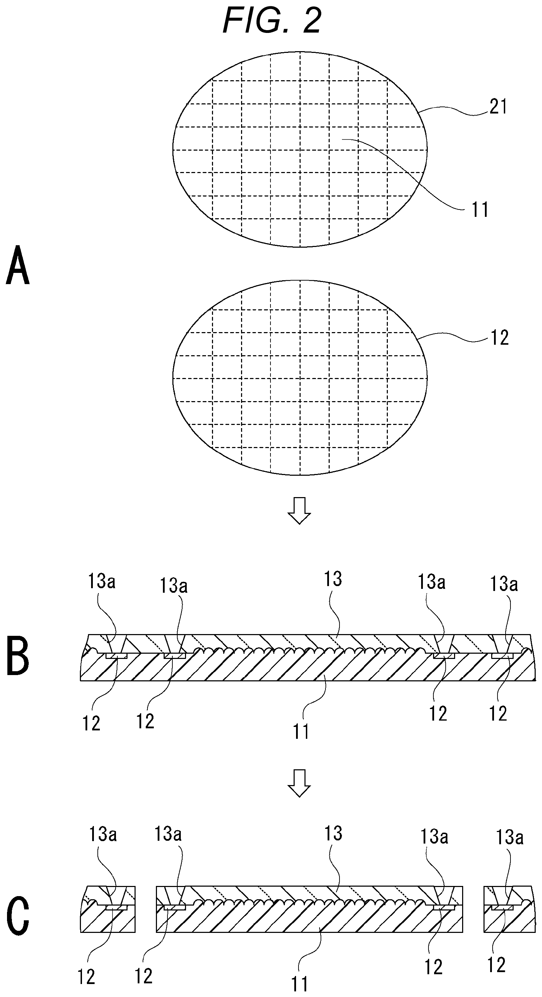

Figs. 2 to 4 are diagrams illustrating a manufacturing method of the imaging device 1 according to the first embodiment. As illustrated in A of Fig. 2, the light transmitting layer 13 is coated on the front surface FA side of a silicon wafer 21 in which the plurality of imaging elements 11 is arranged in a two-dimensional matrix.

The light transmitting layer 13 may be a liquid material or a film material. In a case where the light transmitting layer 13 is a liquid member, for example, the light transmitting layer 13 is applied to the imaging element 11 with a spin coater or the like, and then the light transmitting layer 13 is cured by heating, light irradiation, or the like.

In addition, in a case where the light transmitting layer 13 is a film material, for example, the light transmitting layer 13 is attached to the imaging element 11 by lamination or the like, and then the light transmitting layer 13 is cured by heating, light irradiation, or the like.

Note that, the light transmitting layer 13 may be a photosensitive member or a non-photosensitive member.

Next, as illustrated in Fig. 2B, the through holes 13a are formed at positions facing the respective electrode pads 12 in the light transmitting layer 13. In a case where the light transmitting layer 13 is a photosensitive member, the through holes 13a are formed by photolithography, for example. In addition, in a case where the light transmitting layer 13 is a non-photosensitive member, the through holes 13a are formed by laser processing, for example.

Next, as illustrated in Fig. 2C, the imaging element 11 and the light transmitting layer 13 are formed into chips by dicing.

Next, as illustrated in Fig. 3A, a peeling layer 32 is formed on a temporary substrate 31.

The temporary substrate 31 is a temporary substrate that is used until the respective units constituting the imaging device 1 are integrated by the mold portion 17. Hereinafter, a wafer in which the respective units of the imaging device 1 are integrated by the mold portion 17 is referred to as a pseudo molded wafer.

As will be described in detail later, after the pseudo molded wafer is formed on the temporary substrate 31, the pseudo molded wafer is separated from the temporary substrate 31. Therefore, the peeling layer 32 is formed on the temporary substrate 31.

The peeling layer 32 is broken or decomposed by being applied with energy from the outside and the adhesion force is reduced, so that the temporary substrate 31 and the pseudo molded wafer are separated.

As a peeling method, there is a method of applying physical force, light (laser or UV), heat, or the like, and it is desirable to select a method that does not affect the formation of the pseudo molded wafer and minimizes the residual stress on the pseudo molded wafer.

In a case where light such as UV or laser is applied as the peeling means, a member that transmits light (for example, glass) is used for the temporary substrate 31.

As another peeling method, it is also possible to bond only a part of the temporary substrate 31 and the pseudo molded wafer to each other, hardly bond the others, and cut off the bonded portion.

Next, as illustrated in Fig. 3B, the rewiring layers 16 are formed on the peeling layer 32. At this time, the rewiring layers 16 are each formed around the region where the imaging element 11 is to be arranged later.

Note that a separation layer may be formed between the rewiring layer 16 and the peeling layer 32. The separation layer can reduce damage when the pseudo molded wafer is separated from the temporary substrate 31. In addition, the separation layer is also useful when the rewiring layer 16 and the peeling layer 32 are bonded to each other and separation becomes difficult. The separation layer is removed after the pseudo molded wafer is separated from the temporary substrate 31.

The insulating layer 16b includes a heat-resistant insulating material such as an epoxy resin, polyimide, BCB, or PBO. In addition, at least a part of the same material as that of the light transmitting layer 13 may be used for the insulating layer 16b.

In the wiring layer 16a, a plating seed layer is formed by vacuum vapor deposition or sputtering, resist patterning is performed, and then metal plating is performed to a desired thickness by electroplating. Thereafter, the wiring layer 16a is formed by sequentially performing resist peeling, seed layer removal, drying, plasma cleaning, and the like.

A metal having low electric resistance such as Cu or Al is used for the plating seed layer. In addition, a metal layer (for example, a thin film of Ti, Cr, or the like) for preventing diffusion into the insulating layer 16b and imparting adhesion may be formed between the plating seed layer and the insulating layer 16b.

In a case where the wiring layer 16a includes a plurality of layers, a via hole is formed in the insulating layer 16b, and the upper and lower wiring layers 16a are connected via the insulating layer 16b. As a formation method of the via hole, a method of forming the via hole in the insulating layer 16b by photolithography using a photosensitive resin member, and a method of forming the via hole in the insulating layer 16b by etching, for example, laser processing, using a non-photosensitive resin can be considered.

Next, as illustrated in Fig. 3C, the electronic elements 15 are connected onto the rewiring layer 16.

Next, as illustrated in Fig. 3D, the imaging element 11 and the light transmitting layer 13 are arranged in a face-down manner in the region surrounded by the rewiring layer 16 on the peeling layer 32. That is, here, the imaging element 11 is located on the opposite side to the peeling layer 32 with the light transmitting layer 13 interposed therebetween, and the light transmitting layer 13 is arranged so as to be in contact with the peeling layer 32.

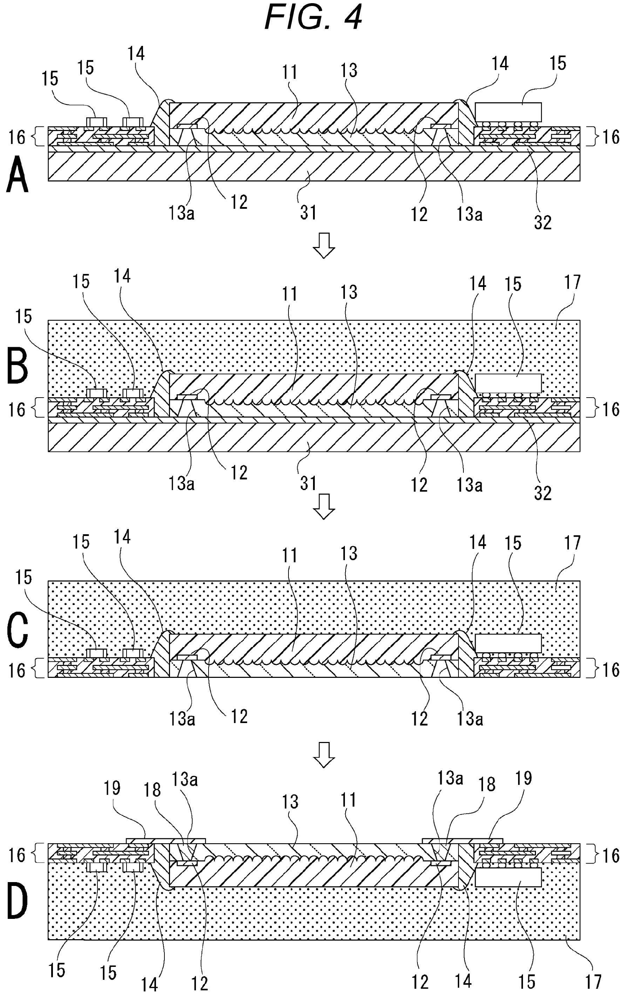

Next, as illustrated in Fig. 4A, the imaging element 11 and the light transmitting layer 13 are fixed by the sealing material 14 so as not to move. At this time, the electronic element 15 may also be fixed by the sealing material 14.

Next, as illustrated in Fig. 4B, the imaging element 11, the light transmitting layer 13, the sealing material 14, the electronic element 15, and the rewiring layer 16 are covered and integrated by the mold portion 17. Accordingly, the pseudo molded wafer is generated.

Next, as illustrated in Fig. 4C, physical force, light, heat, and the like are applied to the peeling layer 32, so that the adhesion between the temporary substrate 31 and the pseudo molded wafer is lowered and the pseudo molded wafer is separated from the temporary substrate 31.

In the pseudo molded wafer, at least the rewiring layer 16 and the light transmitting layer 13 are exposed on one side of the pseudo wafer having the mold portion 17 as a base material.

Next, as illustrated in Fig. 4D, the pillar 18 and the wiring pattern 19 that electrically connect the electrode pad 12 and the rewiring layer 16 are formed. The plating seed layer is formed on a front surface of the pseudo molded wafer on the side where the rewiring layer 16 and the light transmitting layer 13 are exposed (front surface FA side), the resist patterning is performed to form a wiring pattern electrically connectable to the rewiring layer 16 and the electrode pad 12, and then the metal plating is performed to a desired thickness by electroplating. Thereafter, the resist is peeled off, and the seed layer is removed. As a result, the pillar 18 extended from the electrode pad 12 to the front surface of the light transmitting layer 13 through the through hole 13a is formed, and the wiring pattern 19 connecting the pillar 18 to the rewiring layer 16 is formed. Therefore, the pillar 18 and the wiring pattern 19 are integrally formed.

Note that an electronic element may be mounted on the exposed surface of the rewiring layer 16 as necessary.

Next, the pseudo molded wafer is formed into chips by dicing, and the manufacturing of the imaging device 1 is completed.

In the imaging device 1 manufactured in such a manner, since the pixel formation surface of the imaging element 11 is covered with the light transmitting layer 13 during manufacturing, it is possible to prevent exposure to the outside. Therefore, it is possible to reduce exposure of the pixel formation surface of the imaging element 11 to heat, chemicals, and the like during manufacturing of the imaging device 1.

In addition, since it is not necessary to perform wire bonding at the time of connecting the electrode pad 12 of the imaging element 11 and the rewiring layer 16, the imaging device 1 can achieve reduction in size and height.

Note that the order of the manufacturing method described above is an example, and a part of the order may be changed. For example, the order of arrangement of the imaging element 11 and the light transmitting layer 13 arranged on the peeling layer 32 and the rewiring layer 16 may be reversed. In addition, the order of arrangement of the electronic elements 15 may be after the imaging element 11 and the light transmitting layer 13 are arranged on the peeling layer 32. Furthermore, the order of arrangement of the electronic elements 15 may be after the imaging element 11 and the light transmitting layer 13 are fixed by the sealing material 14.

### [1.3. First Application Example]

Fig. 5 is a diagram illustrating configurations of the imaging element 11 and the light transmitting layer 13 of a first application example according to the first embodiment.

As illustrated in Fig. 3D, at the time of manufacturing the imaging device 1, the imaging element 11 and the light transmitting layer 13 are arranged in a face-down manner in the region surrounded by the rewiring layer 16 on the peeling layer 32. At this time, if the imaging element 11 and the light transmitting layer 13 are simply arranged on the peeling layer 32, it may be difficult to maintain the positioning accuracy.

Therefore, as illustrated in Fig. 5, in the imaging device 1, for example, substantially L-shaped positioning holes 13b may be formed in the light transmitting layer 13.

In the imaging element 11, the electrode pads 12 are arranged so as to surround the pixel region 11a. The electrode pads 12 are formed, for example, along three sides of the pixel region 11a.

In the light transmitting layer 13, the through holes 13a are formed at positions facing the respective electrode pads 12. Therefore, the through holes 13a are also formed along the three sides of the pixel region 11a, for example.

For example, three positioning holes 13b are formed so as to be aligned with the through holes 13a arranged along the sides of the pixel region 11a. Two of the three positioning holes 13b are formed at a side where the through hole 13a is not formed among the sides of the pixel region 11a. In addition, the remaining positioning hole 13b is formed at a corner between the two sides where the through holes 13a are formed among the sides of the pixel region 11a.

The positioning hole 13b is formed in the same step as the through hole 13a. In a case where the light transmitting layer 13 is a photosensitive member, the positioning hole 13b is formed together with the through hole 13a by photolithography, for example. In addition, in a case where the light transmitting layer 13 is a non-photosensitive member, the positioning hole 13b is formed together with the through hole 13a by laser processing, for example.

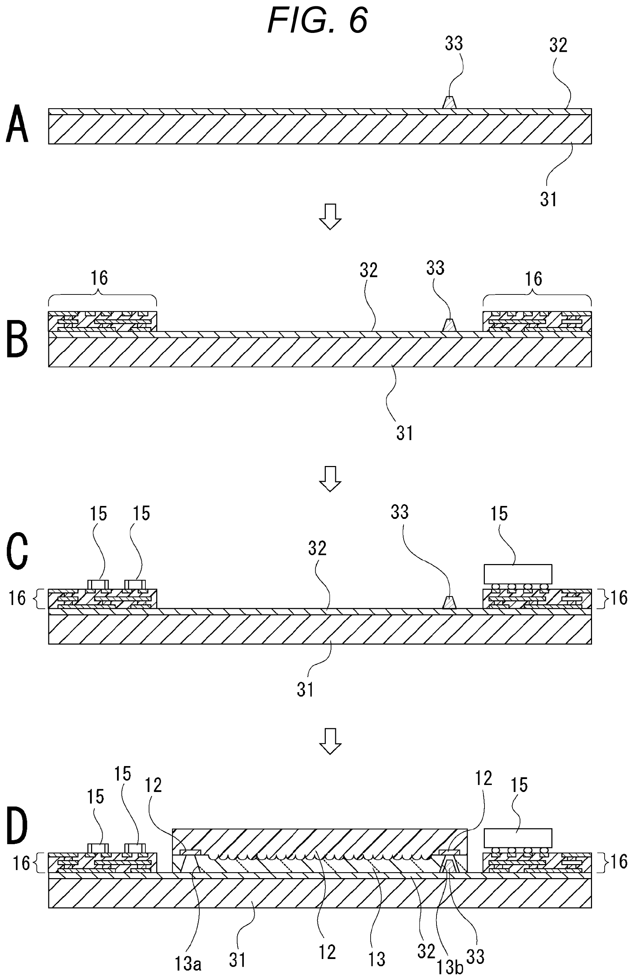

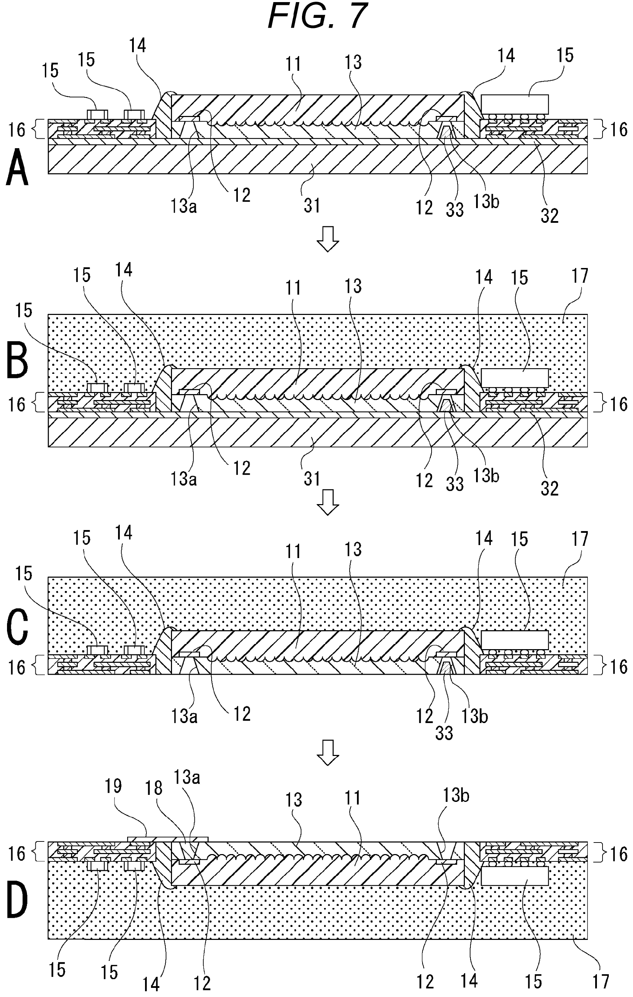

Figs. 6 and 7 are diagrams illustrating a manufacturing method of the imaging device 1 of the first application example according to the first embodiment. Next, the manufacturing method of the imaging device 1 of the first application example will be described. However, the steps until the imaging element 11 and the light transmitting layer 13 are formed into chips are the same as the steps illustrated in Figs. 2A to 2C except for the step of forming the positioning hole 13b described above, and thus the description thereof will be omitted.

As illustrated in Fig. 6A, the peeling layer 32 is formed on the temporary substrate 31. In addition, a pattern 33 for alignment is formed on the peeling layer 32. Since the pattern 33 is fitted into the positioning hole 13b as described later, the pattern 33 is formed in accordance with the arrangement position of the imaging element 11 and the light transmitting layer 13 on the peeling layer 32. Note that the pattern 33 may include a conductive material or include an insulating material.

Next, after the rewiring layer 16 is formed on the peeling layer 32 as illustrated in Fig. 6B, the electronic element 15 is connected to the rewiring layer 16 as illustrated in Fig. 6C.

Next, as illustrated in Fig. 6D, the imaging element 11 and the light transmitting layer 13 are arranged in a face-down manner in the region surrounded by the rewiring layer 16 on the peeling layer 32. At this time, the imaging element 11 and the light transmitting layer 13 are arranged such that the pattern 33 is inserted into the positioning hole 13b.

Next, as illustrated in Fig. 7A, the imaging element 11 and the light transmitting layer 13 are fixed by the sealing material 14, and as illustrated in Fig. 7B, the imaging element 11, the light transmitting layer 13, the sealing material 14, the electronic element 15, and the rewiring layer 16 are covered and integrated by the mold portion 17.

Next, as illustrated in Fig. 7C, physical force, light, heat, and the like are applied to the peeling layer 32, so that the pseudo molded wafer is separated from the temporary substrate 31. At this time, the pattern 33 may or may not be removed from the positioning hole 13b.

Next, as illustrated in Fig. 7D, the pillar 18 and the wiring pattern 19 that electrically connect the electrode pad 12 and the rewiring layer 16 are formed, the pseudo molded wafer is formed into chips by dicing, and the manufacturing of the imaging device 1 of the first application example is completed.

### [1.4. Second Application Example]

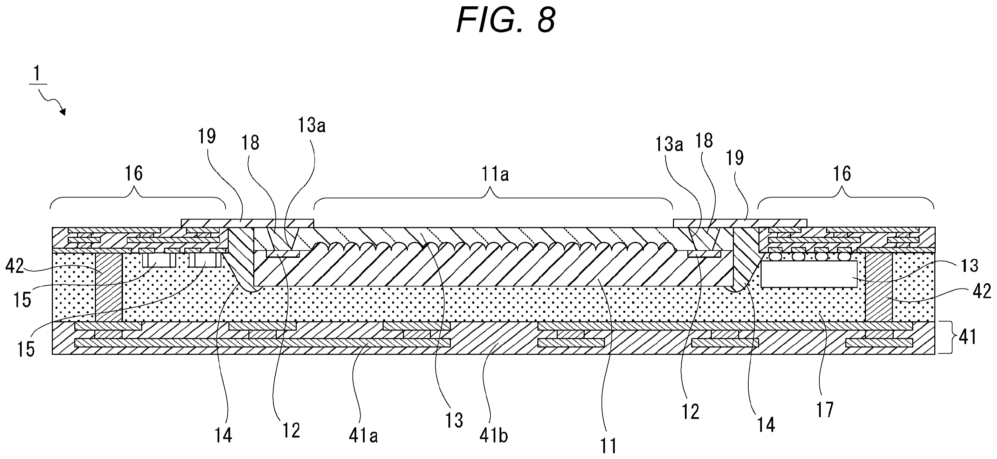

Fig. 8 is a diagram illustrating a configuration of an imaging device 1A of a second application example according to the first embodiment. As illustrated in Fig. 8, in the imaging device 1A of the second application example, a second rewiring layer 41 is arranged on the back surface FB side of the mold portion 17.

Similarly to the rewiring layer 16, the second rewiring layer 41 includes wiring layers 41a and an insulating layer 41b. In the second rewiring layer 41, the wiring layers 41a are laminated from the front surface FA side to the back surface FB side, and the insulating layer 41b is arranged between the wiring layers 41a.

In the second rewiring layer 41, the wiring layer 41a provided closest to the front surface FA side is arranged so as to be exposed.

The wiring layer 41a provided closest to the front surface FA side is electrically connected to the insulating layer 16b provided closest to the back surface FB side in the rewiring layer 16 via a mold through via 42 formed in the mold portion 17.

The mold through via 42 is, for example, a conductive pillar, and is formed by electroplating. The mold through via 42 may be provided with a resist as necessary. The resist may be a resist having a thicker film than that used for forming the wiring.

In this case, after the imaging device 1 is generated as in the first embodiment (after Fig. 4D), a hole reaching the rewiring layer 16 is formed in the mold portion 17 from the back surface FB side, and the mold through via 42 is formed in the hole by electroplating. Thereafter, the second rewiring layer 41 is formed.

Note that the mold through via 42 may include a solder bump or the like instead of the conductive pillar.

In addition, as the mold through via 42, a conductive pillar formed in advance may be used.

In this case, after the imaging element 11 and the light transmitting layer 13 are fixed with the sealing material 14 as in the first embodiment (after Fig. 4A), the conductive pillar is connected onto the rewiring layer 16 using solder or a conductive adhesive. Next, these are covered with the mold portion 17, and thereafter, a surface of the mold portion 17 opposite to the temporary substrate 31 is removed in parallel with the temporary substrate 31 until a surface of the conductive pillar is exposed and has a desired thickness. As a removal method, grinding, polishing, and cutting can be considered.

The second rewiring layer 41 is formed on the surface where the conductive pillar is exposed. Next, after the pseudo molded wafer is peeled off from the temporary substrate 31, the pillar 18 and the wiring pattern 19 that connect the electrode pad 12 and the rewiring layer 16 are formed. At this time, in a case where the pseudo molded wafer is difficult to handle, the pillar 18 and the wiring pattern 19 may be formed after the back surface FB side, that is, the second rewiring layer 41 side, is fixed with a temporary substrate on which a peeling material is formed. As the peeling material, it is preferable to use a material capable of adhering and fixing the pseudo molded wafer and capable of peeling with heat, light, or the like.

Note that the timing at which the pillar 18 and the wiring pattern 19 that connect the electrode pad 12 and the rewiring layer 16 are formed may be before the conductive pillar is exposed. That is, the steps after the step of exposing the conductive pillar may be performed after the pseudo molded wafer is produced and then the front surface side is fixed again with the temporary substrate on which the peeling material is formed.

### [1.5. Third Application Example]

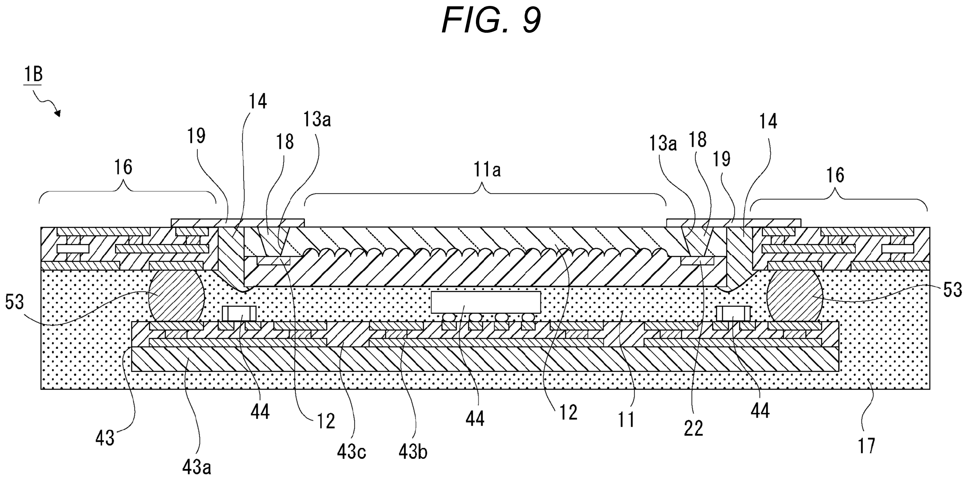

Fig. 9 is a diagram illustrating a configuration of an imaging device 1B of a third application example according to the first embodiment. As illustrated in Fig. 9, in the imaging device 1B of the third application example, a second rewiring layer 43 is formed inside the mold portion 17.

The second rewiring layer 43 includes a rewiring substrate 43a, wiring layers 43b, and an insulating layer 43c.

The rewiring substrate 43a is formed of a substrate including inorganic material such as Si, ceramics, or glass, or a flexible substrate. In the second rewiring layer 43, the wiring layers 43b are laminated on the rewiring substrate 43a, and the insulating layer 43c is arranged between the wiring layers 43b.

In the second rewiring layer 43, the wiring layer 43b provided closest to the front surface FA side is arranged so as to be exposed.

The wiring layer 43b provided closest to the front surface FA side is electrically connected to the insulating layer 16b provided closest to the back surface FB side in the rewiring layer 16 via a solder dump 44, for example.

Note that the rewiring layer 16 and the second rewiring layer 43 may be connected by a conductive pillar or a conductive adhesive instead of the solder dump 44.

As a matching method, after the imaging element 11 and the light transmitting layer 13 are fixed by the sealing material 14 as in the first embodiment (after Fig. 4A), the solder dump 44 and the second rewiring layer 43 are arranged so as to be connected to the rewiring layer 16. Next, the imaging element 11, the light transmitting layer 13, the sealing material 14, the electronic element 15, the rewiring layer 16, the second rewiring layer 43, and the solder dump 44 are integrated by the mold portion 17.

### <2. Second Embodiment>

### [2.1. Configuration of Imaging Device]

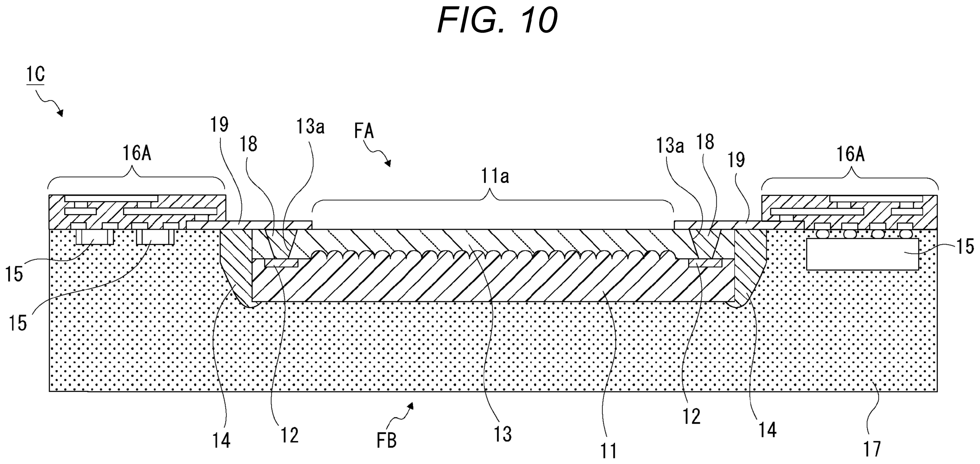

Fig. 10 is a cross-sectional schematic view illustrating a configuration of an imaging device 1C according to a second embodiment. Note that the same components as those of the imaging device 1 in the first embodiment are denoted by the same reference numerals, and the description thereof will be omitted.

In the imaging device 1 according to the first embodiment, the front surface of the light transmitting layer 13 and the front surface of the rewiring layer 16 are arranged so as to be flush with each other. As illustrated in Fig. 10, in the imaging device 1C according to the second embodiment, a front surface (surface on a front surface FA side) of a light transmitting layer 13 and a back surface (surface on a back surface FB side) of a rewiring layer 16A are arranged so as to be flush with each other.

In the imaging device 1C, the light transmitting layer 13 is formed on the front surface FA side of an imaging element 11. In the light transmitting layer 13, through holes 13a are formed at positions facing respective electrode pads 12.

The imaging element 11 and the light transmitting layer 13 are covered with a sealing material 14 so as to surround an outer periphery. An electronic element 15 is provided on an outer side of the imaging element 11 and the light transmitting layer 13 in a planar direction. The front surface of the light transmitting layer 13 and a front surface of the electronic element 15 are arranged substantially flush with each other.

The imaging element 11, the light transmitting layer 13, the sealing material 14, and the electronic element 15 are integrated by a mold portion 17 including, for example, a resin material.

A rewiring layer 16A is arranged on an outer side of the imaging element 11 and the light transmitting layer 13 in a planar direction and on the front surface FA side of the electronic element 15. The rewiring layer 16 includes wiring layers 16a and an insulating layer 16b. In the rewiring layer 16A, the wiring layer 16a arranged closest to the back surface FB side is electrically connected to the electrode pad 12 via a pillar 18 and a wiring pattern 19.

The wiring pattern 19 is formed so as to connect a position facing the pillar 18 and a position facing the wiring layer 16a arranged closest to the back surface FB side in the rewiring layer 16, and is electrically connected to the pillar 18 and the wiring layer 16a at a corresponding one of both end portions.

### [2.2. Manufacturing Method of Imaging Device]

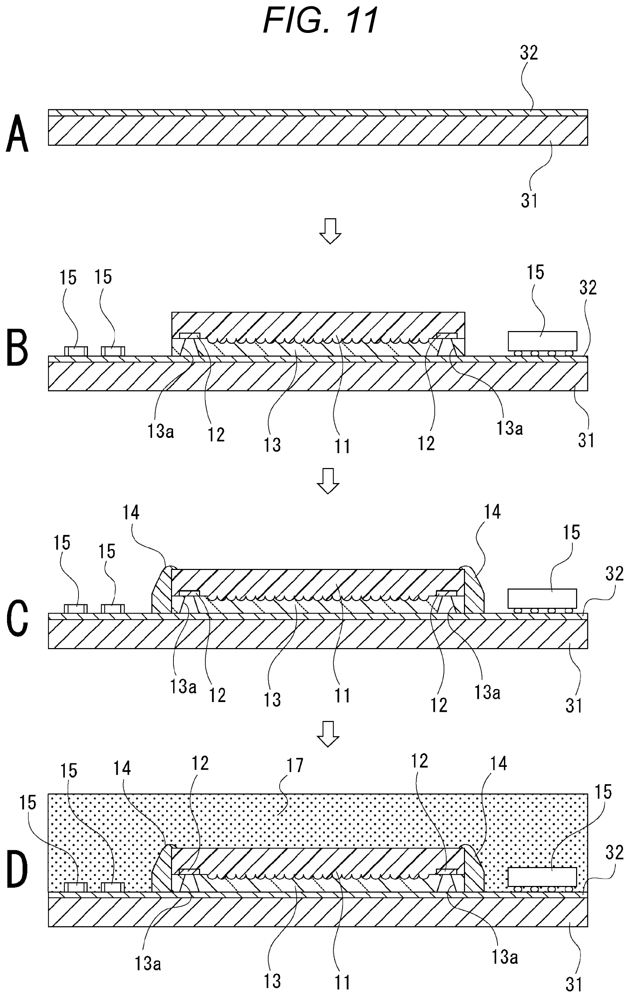

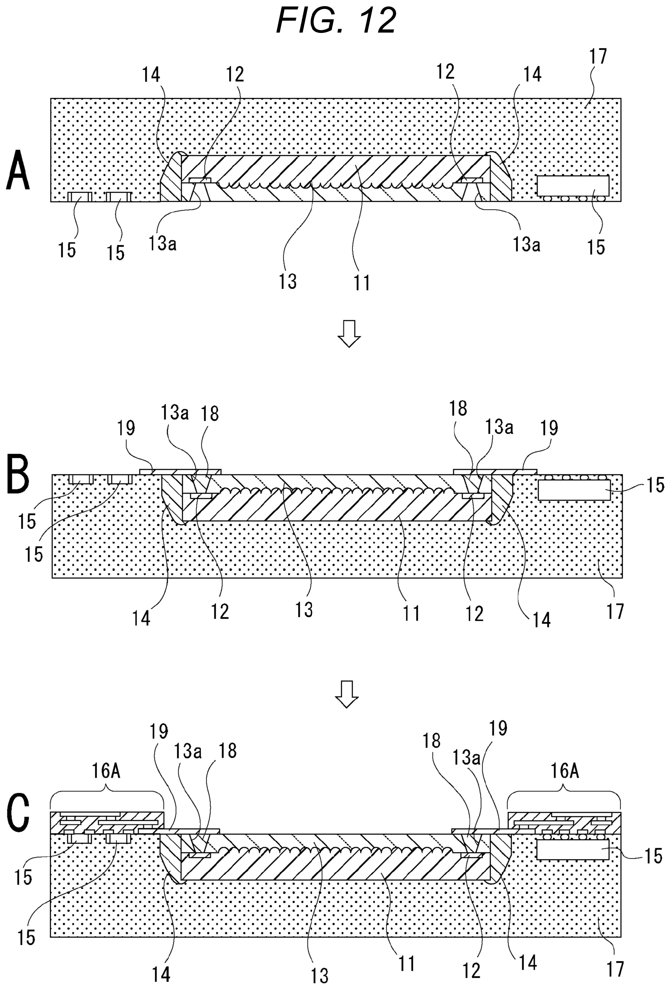

Figs. 11 and 12 are diagrams illustrating a manufacturing method of the imaging device 1C according to the second embodiment. However, the steps until the imaging element 11 and the light transmitting layer 13 are formed into chips are the same as the steps illustrated in Figs. 2A to 2C in the first embodiment, and thus the description thereof will be omitted.

Next, as illustrated in Fig. 11A, a peeling layer 32 is formed on a temporary substrate 31.

Next, as illustrated in Fig. 11B, the electronic element 15 is arranged on the peeling layer 32, and the imaging element 11 and the light transmitting layer 13 are arranged in a face-down manner.

Next, as illustrated in Fig. 11C, the imaging element 11 and the light transmitting layer 13 are fixed by the sealing material 14 so as not to move.

Next, as illustrated in Fig. 11D, the imaging element 11, the light transmitting layer 13, the sealing material 14, and the electronic element 15 are covered with the mold portion 17. Accordingly, a pseudo molded wafer is generated.

Next, as illustrated in Fig. 12A, physical force, light, heat, and the like are applied to the peeling layer 32, so that the pseudo molded wafer is separated from the temporary substrate 31.

Next, as illustrated in Fig. 12B, the pillar 18 and the wiring pattern 19 for electrically connecting the electrode pad 12 and the rewiring layer 16 are formed. A plating seed layer is formed on a front surface of the pseudo molded wafer on the side where the light transmitting layer 13 is exposed (front surface FA side), the resist patterning is performed to form a wiring pattern electrically connectable to the electrode pad 12 and the wiring layers 16a of the rewiring layer 16A formed later, and then the metal plating is performed to a desired thickness by electroplating. Thereafter, the resist is peeled off, and the seed layer is removed. As a result, the pillar 18 extended from the electrode pad 12 to the front surface of the light transmitting layer 13 through the through hole 13a is formed, and the wiring pattern 19 connecting the pillar 18 to the rewiring layer 16A is formed.

Next, as illustrated in Fig. 12C, the rewiring layer 16 is formed so as to be connected to the wiring pattern 19 on the outer side, in the planar direction, of the imaging element 11 and the light transmitting layer 13 on the mold portion 17.

Next, the pseudo molded wafer is formed into chips by dicing, and the manufacturing of the imaging device 1 is completed.

### <3. Third Embodiment>

### [3.1. Configuration of Imaging Device]

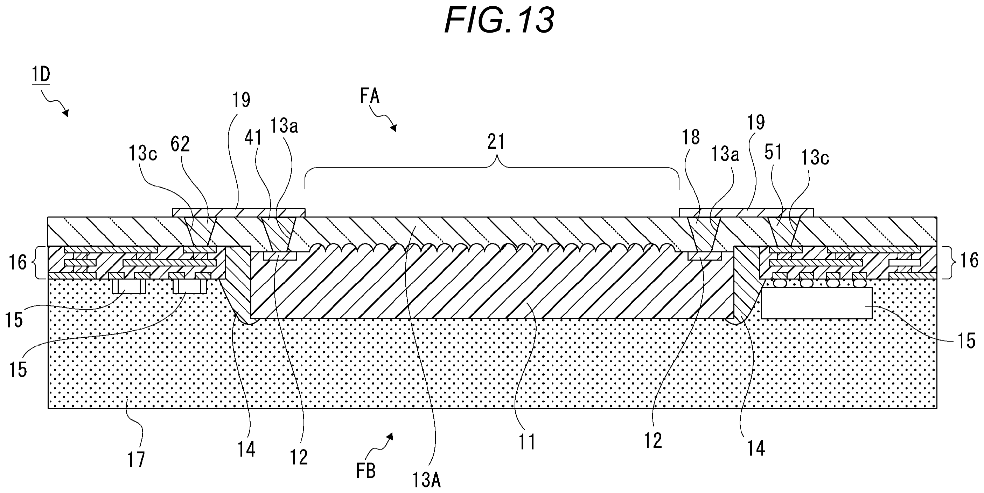

Fig. 13 is a cross-sectional schematic view illustrating a configuration of an imaging device 1D according to a third embodiment. Note that the same components as those of the imaging device 1 in the first embodiment are denoted by the same reference numerals, and the description thereof will be omitted.

In the imaging device 1 according to the first embodiment, the front surface of the light transmitting layer 13 and the front surface of the rewiring layer 16 are arranged so as to be flush with each other, and the light transmitting layer 13 is arranged so as to cover only the imaging element 11.

As illustrated in Fig. 13, in the imaging device 1D according to the third embodiment, a front surface of an imaging element 11 and a front surface of a rewiring layer 16 are arranged so as to be substantially flush with each other, and furthermore, a light transmitting layer 13A is formed so as to cover the imaging element 11 and the rewiring layer 16.

In the imaging device 1D, the light transmitting layer 13A is formed on a front surface FA side of the imaging element 11 so as to cover the imaging element 11 and the rewiring layer 16 arranged on an outer side of the imaging element 11 in a planar direction. The front surface of the imaging element 11 and the front surface of the rewiring layer 16 are arranged substantially flush with each other.

In the light transmitting layer 13A, through holes 13a are formed at positions facing respective electrode pads 12. In addition, in the light transmitting layer 13A, the through holes 13c are formed at positions facing the respective wiring layers 16a on the front surface side in the rewiring layer 16.

The imaging element 11 is covered with a sealing material 14 so as to surround the outer periphery. The electronic element 15 and the rewiring layer 16 are arranged on the outer side of the imaging element 11 in the planar direction.

The imaging element 11, the light transmitting layer 13, the sealing material 14, the electronic element 15, and the rewiring layer 16 are integrated by a mold portion 17.

On the front surface FA side of the light transmitting layer 13A, the wiring layer 16a is electrically connected to the electrode pad 12 via the pillar 18, a pillar 51, and the wiring pattern 19.

The pillar 18 is formed so as to fill the through hole 13a, and is electrically connected to the electrode pad 12 on the back surface FB side and is electrically connected to the wiring pattern 19 on the front surface FA side.

The pillar 51 is formed so as to fill the through hole 13c, and is electrically connected to the rewiring layer 16 on the back surface FB side and is electrically connected to the wiring pattern 19 on the front surface FA side.

The wiring pattern 19 is formed so as to connect a position facing the pillar 18 and a position facing the pillar 51, and is electrically connected to the pillar 18 and the pillar 51 at a corresponding one of both end portions.

### [3.2. Manufacturing Method of Imaging Device]

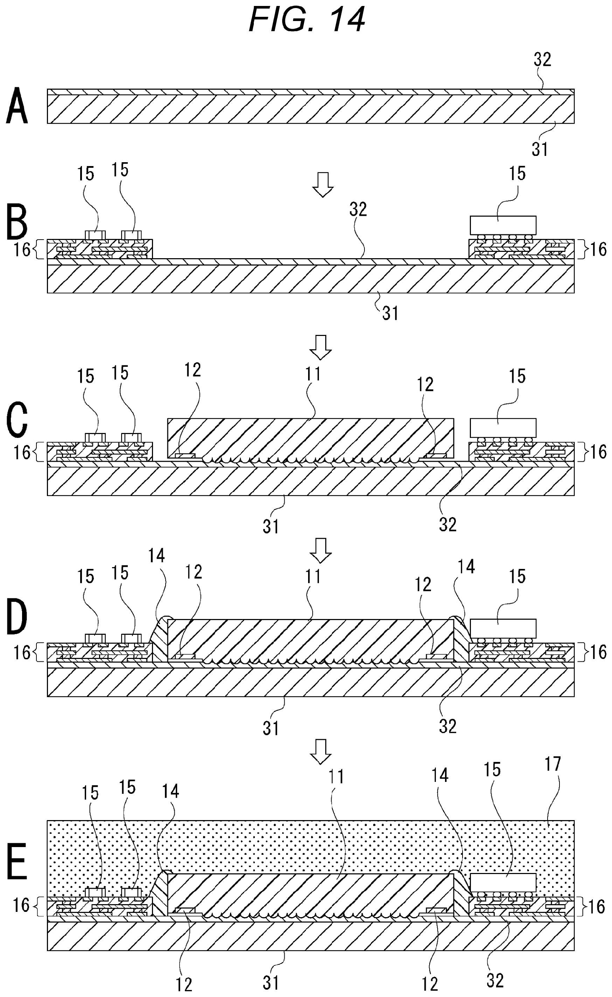

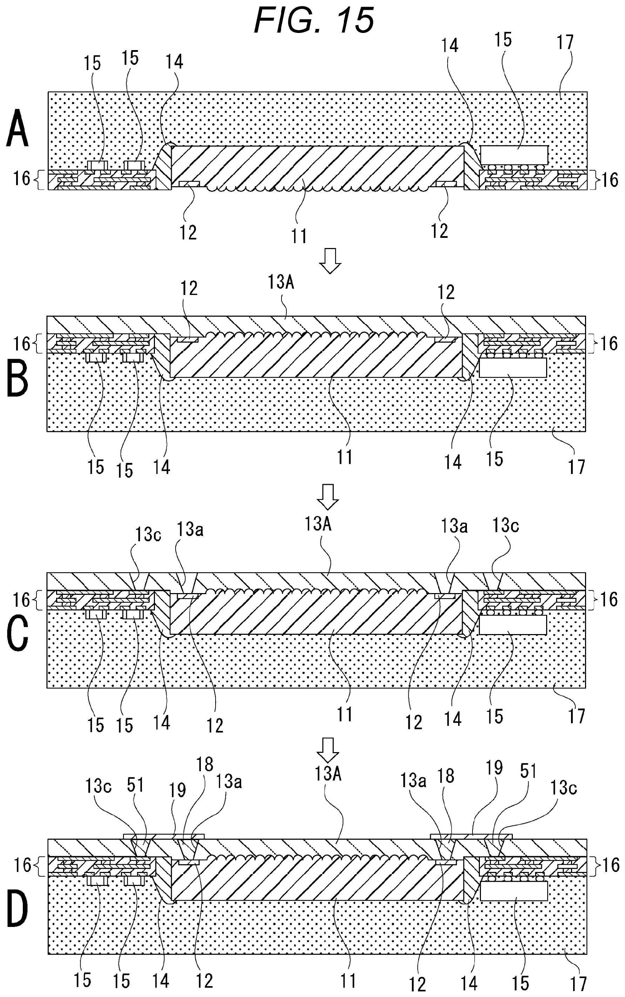

Figs. 14 and 15 are diagrams illustrating a manufacturing method of the imaging device 1D according to the third embodiment. However, the steps until the imaging element 11 and the light transmitting layer 13 are formed into chips are the same as the steps illustrated in Figs. 2A to 2C in the first embodiment, and thus the description thereof will be omitted.

Next, as illustrated in Fig. 14A, a peeling layer 32 is formed on a temporary substrate 31.

Next, as illustrated in Fig. 14B, after the rewiring layer 16 is formed on the peeling layer 32, the electronic element 15 is connected to the rewiring layer 16.

Next, as illustrated in Fig. 14C, the imaging element 11 is arranged in a face-down manner in the region surrounded by the rewiring layer 16 on the peeling layer 32.

Next, as illustrated in Fig. 14D, the imaging element 11 is fixed by the sealing material 14 so as not to move. There is a case where the front surface of the imaging element 11 is not flat, and the sealing material 14 can prevent the mold portion 17 from flowing into the front surface of the imaging element 11.

Next, as illustrated in Fig. 14E, the imaging element 11, the sealing material 14, the electronic element 15, and the rewiring layer 16 are covered with the mold portion 17. Accordingly, a pseudo molded wafer is generated.

Next, as illustrated in Fig. 15A, physical force, light, heat, and the like are applied to the peeling layer 32, so that the pseudo molded wafer is separated from the temporary substrate 31.

Next, as illustrated in Fig. 15B, the light transmitting layer 13A is formed on the front surface FA side of the imaging element 11 and the rewiring layer 16.

Next, as illustrated in Fig. 15C, the through hole 13a and the through hole 13c are formed at positions corresponding to the electrode pad 12 and the wiring layer 16a arranged closest to the front surface side in the rewiring layer 16, respectively.

Next, as illustrated in Fig. 15D, the pillar 18, the pillar 51, and the wiring pattern 19 that electrically connect the electrode pad 12 and the wiring layer 16a arranged closest to the front surface side in the rewiring layer 16 are formed. A plating seed layer is formed on a front surface of the light transmitting layer 13, the resist patterning is performed to form a wiring pattern electrically connectable to the rewiring layer 16 and the electrode pad 12, and then the metal plating is performed to a desired thickness by electroplating. Thereafter, the resist is peeled off, and the seed layer is removed. As a result, the pillar 18, the pillar 51, and the wiring pattern 19 are formed.

Next, the pseudo molded wafer is formed into chips by dicing, and the manufacturing of the imaging device 1 is completed.

### <4. Modifications>

Note that the embodiments are not limited to the specific examples described above, and may be configured as various modifications.

For example, the configurations of the first, second, and third application examples described in the first embodiment may be applied to the imaging device 1C in the second embodiment and the imaging device 1D in the third embodiment.

Furthermore, in the embodiments described above, the imaging element 11 has been described as an example of the semiconductor substrate. However, the semiconductor substrate is not limited to the imaging element 11, and may be, for example, a substrate including an LED that emits light when electricity flows.

In addition, the imaging device 1 has been described as an example of the semiconductor device. However, the semiconductor device is not limited to the imaging device 1, and may be, for example, a lighting device including a substrate including an LED that emits light when electricity flows.

### <5. Summary>

As described above, a semiconductor device (imaging device 1 or 1A to 1D) as an embodiment includes a semiconductor substrate (imaging element 11), a light transmitting layer 13 that is arranged on a first surface (pixel formation surface, front surface FA) side of the semiconductor substrate and transmits light having a predetermined wavelength, a rewiring layer 16 or 16A at least a part of which is formed on an outer side of the semiconductor substrate in a planar direction, a mold portion 17 that integrates at least the semiconductor substrate and the light transmitting layer 13 on a second surface (back surface FB) side opposite to the first surface, a through hole 13a provided at a position facing an electrode (electrode pad 12) of the semiconductor substrate in the light transmitting layer 13, and a wiring portion (pillar 18, wiring pattern 19, or pillar 51) that electrically connects the electrode and the rewiring layer 16 or 16A.

As a result, for example, since the pixel formation surface of the imaging element 11 is covered with the light transmitting layer 13, it is possible to prevent the pixel formation surface from being exposed to the outside at the time of manufacturing the imaging device 1. Therefore, it is possible to reduce exposure of the pixel formation surface of the imaging element 11 to heat, chemicals, and the like during manufacturing of the imaging device 1.

In addition, since it is not necessary to perform wire bonding at the time of connecting the electrode pad 12 of the imaging element 11 and the rewiring layer 16, the imaging device 1 can achieve reduction in size and height.

Thus, the imaging device 1 can protect the pixel formation surface of the semiconductor substrate at the time of manufacturing while achieving reduction in size and height.

The light transmitting layer 13 and the rewiring layer 16 are integrated by the mold portion 17 to be arranged flush with each other on the first surface side, and the wiring portion is arranged along the light transmitting layer 13 in the planar direction.

As described above, by arranging the light transmitting layer 13 and the rewiring layer 16 flush with each other on the front surface FA side, the wiring pattern 19 can be formed at the shortest route without unevenness in the front-back direction along the front surfaces of the light transmitting layer 13 and the rewiring layer 16.

Therefore, the imaging device 1 can further achieve reduction in size and height.

A positioning hole 13b for positioning is formed in the light transmitting layer 13.

As a result, the positional accuracy when arranging the imaging element 11 on the peeling layer 32 at the time of manufacturing the imaging device 1 can be improved.

Three of the positioning holes 13b are formed in the light transmitting layer 13.

As a result, the wrong arrangement direction of the imaging element 11 at the time of manufacturing the imaging device 1 can be reduced.

There are further provided a second rewiring layer 41 formed on the second surface side of the mold portion 17, and a connection portion (mold through via 42) that is formed in the mold portion 17 and electrically connects the rewiring layer 16 and the second rewiring layer.

Even in a case where all the wirings cannot be formed in the rewiring layer 16, the second rewiring layer 41 is formed on the back surface FB side of the mold portion 17, and the rewiring layer 16 and the second rewiring layer 41 are electrically connected by the mold through via 42.

As a result, the imaging device 1A can easily form additional wiring, and can achieve reduction in size and height.

There are further provided a second rewiring layer 43 formed inside the mold portion 17, and a connection portion (solder dump 44) that is formed in the mold portion 17 and electrically connects the rewiring layer 16 and the second rewiring layer 43.

Even in a case where all the wirings cannot be formed in the rewiring layer 16, the second rewiring layer 43 is formed inside the mold portion 17, and the rewiring layer 16 and the second rewiring layer 43 are electrically connected by the solder dump 44.

As a result, the imaging device 1B can easily form additional wiring, and can achieve reduction in size and height.

The mold portion 17 is formed to be flush with a front surface of the light transmitting layer 13 on the first surface side, and the rewiring layer 16A is arranged on the outer side, in the planar direction, of the mold portion 17 on the first surface side of the semiconductor substrate.

Even in a case of adopting a structure in which the rewiring layer 16A is arranged on the front surface FA side of the front surface of the light transmitting layer 13, for example, it is possible to prevent the pixel formation surface of the imaging element 11 from being exposed to the outside at the time of manufacturing the imaging device 1C.

In addition, since it is not necessary to perform wire bonding at the time of connecting the electrode pad 12 of the imaging element 11 and the rewiring layer 16A, the imaging device 1C can achieve reduction in size and height.

Thus, the imaging device 1C can protect the pixel formation surface of the semiconductor substrate at the time of manufacturing while achieving reduction in size and height.

The wiring portion electrically connects the electrode and a wiring layer 16a closest to the second surface side in the rewiring layer 16A.

As a result, in the imaging device 1C, the wiring pattern 19 can be formed without unevenness in the front-back direction along the front surface of the light transmitting layer 13, and thus reduction in size and height can be achieved.

The light transmitting layer 13A is formed to cover the semiconductor substrate and the first surface side of the rewiring layer 16.

As a result, in the imaging device 1D, the rewiring layer 16 can be covered with the light transmitting layer 13A in addition to the imaging element 11.

In addition, since it is not necessary to perform wire bonding at the time of connecting the electrode pad 12 of the imaging element 11 and the rewiring layer 16, the imaging device 1D can achieve reduction in size and height.

Thus, the imaging device 1D can protect the pixel formation surface of the semiconductor substrate at the time of manufacturing while achieving reduction in size and height.

There is further provided a second through hole (through hole 13c) provided at a position facing the rewiring layer 16 in the light transmitting layer 13A, and the wiring portion electrically connects the electrode and the rewiring layer 16 via the through hole 13a and the second through hole.

As a result, in the imaging device 1D, the wiring pattern 19 can be formed without unevenness in the front-back direction along the front surface of the light transmitting layer 13, and thus reduction in size and height can be achieved.

The semiconductor substrate is the imaging element 11 in which a plurality of pixels that convert incident light into an electric signal is arranged in a two-dimensional matrix, for example.

As described above, the imaging device 1 including the imaging element 11 can also protect the pixel formation surface of the imaging element 11 at the time of manufacturing while achieving reduction in size and height.

A manufacturing method of a semiconductor device includes forming a light transmitting layer 13 that transmits light having a predetermined wavelength on a first surface (pixel formation surface) side of a semiconductor substrate (imaging element 11), forming a through hole 13a at a position facing an electrode (electrode pad 12) of the semiconductor substrate in the light transmitting layer 13, arranging a rewiring layer 16 on a temporary substrate 31 and arranging the semiconductor substrate and the light transmitting layer 13 in a face-down manner, integrating the semiconductor substrate, the light transmitting layer 13, and the rewiring layer 16 by a mold portion 17, separating the integrated semiconductor substrate, the light transmitting layer 13, the rewiring layer 16, and the mold portion 17 from the temporary substrate 31, and connecting the electrode of the semiconductor substrate and the rewiring layer 16 by a wiring portion (pillar 18 or wiring pattern 19).

Also in this manufacturing method, the effects similar to those of the semiconductor device described above can be achieved.

Note that the effects described in the present specification are merely examples and are not limited, and other effects may be provided.

### <6. Present Technology>

Note that, the present technology can also adopt the following configurations.
(1) A semiconductor device including:
   a semiconductor substrate;
   a light transmitting layer that is arranged on a side of a first surface of the semiconductor substrate and transmits light having a predetermined wavelength;
   a rewiring layer at least a part of which is formed on an outer side of the semiconductor substrate in a planar direction;
   a mold portion that integrates at least the semiconductor substrate and the light transmitting layer on a side of a second surface opposite to the first surface;
   a through hole provided at a position facing an electrode of the semiconductor substrate in the light transmitting layer; and
   a wiring portion that electrically connects the electrode and the rewiring layer.
(2) The semiconductor device according to (1), in which
   the light transmitting layer and the rewiring layer are integrated by the mold portion to be arranged flush with each other on the first surface side, and
   the wiring portion is arranged along the light transmitting layer in the planar direction.
(3) The semiconductor device according to (1) or (2), in which a positioning hole for positioning is formed in the light transmitting layer.
(4) The semiconductor device according to (3), in which three of the positioning holes are formed in the light transmitting layer.
(5) The semiconductor device according to any one of (1) to (4), further including:
   a second rewiring layer formed on the second surface side of the mold portion; and
   a connection portion that is formed in the mold portion and electrically connects the rewiring layer and the second rewiring layer.
(6) The semiconductor device according to any one of (1) to (5), further including:
   a second rewiring layer formed inside the mold portion; and
   a connection portion that is formed in the mold portion and electrically connects the rewiring layer and the second rewiring layer.
(7) The semiconductor device according to any one of (1) and (3) to (6), in which
   the mold portion is formed to be flush with a front surface of the light transmitting layer on the first surface side, and
   the rewiring layer is arranged on the outer side, in the planar direction, of the mold portion on the first surface side of the semiconductor substrate.
(8) The semiconductor device according to (7), in which
   the wiring portion electrically connects the electrode and a wiring layer closest to the second surface side in the rewiring layer.
(9) The semiconductor device according to any one of (1) and (3) to (6), in which
   the light transmitting layer is formed to cover the semiconductor substrate and the first surface side of the rewiring layer.
(10) The semiconductor device according to (9), further including
   a second through hole provided at a position facing the rewiring layer in the light transmitting layer, in which
   the wiring portion electrically connects the electrode and the rewiring layer via the through hole and the second through hole.
(11) The semiconductor device according to any one of (1) to (10), in which
   the semiconductor substrate is an imaging element in which a plurality of pixels that convert incident light into an electric signal is arranged in a two-dimensional matrix, for example.
(12) A manufacturing method of a semiconductor device, including:
   forming a light transmitting layer that transmits light having a predetermined wavelength on a side of a first surface of a semiconductor substrate;
   forming a through hole at a position facing an electrode of the semiconductor substrate in the light transmitting layer;
   arranging a rewiring layer on a temporary substrate and arranging the semiconductor substrate and the light transmitting layer in a face-down manner;
   integrating the semiconductor substrate, the light transmitting layer, and the rewiring layer by a mold portion;
   separating the integrated semiconductor substrate, the light transmitting layer, the rewiring layer, and the mold portion from the temporary substrate; and
   connecting the electrode of the semiconductor substrate and the rewiring layer by a wiring portion.

### REFERENCE SIGNS LIST

- 1: Imaging device
- 11: Imaging element
- 12: Electrode pad
- 13: Light transmitting layer
- 14: Sealing material
- 15: Electronic element
- 16: Rewiring layer
- 17: Mold portion
- 18: Pillar
- 19: Wiring pattern

## Claims

1. A semiconductor device comprising:
a semiconductor substrate;
a light transmitting layer that is arranged on a side of a first surface of the semiconductor substrate and transmits light having a predetermined wavelength;
a rewiring layer at least a part of which is formed on an outer side of the semiconductor substrate in a planar direction;
a mold portion that integrates at least the semiconductor substrate and the light transmitting layer on a side of a second surface opposite to the first surface;
a through hole provided at a position facing an electrode of the semiconductor substrate in the light transmitting layer; and
a wiring portion that electrically connects the electrode and the rewiring layer.

2. The semiconductor device according to claim 1, wherein
the light transmitting layer and the rewiring layer are integrated by the mold portion to be arranged flush with each other on the first surface side, and
the wiring portion is arranged along the light transmitting layer in the planar direction.

3. The semiconductor device according to claim 1, wherein
a positioning hole for positioning is formed in the light transmitting layer.

4. The semiconductor device according to claim 3, wherein
three of the positioning holes are formed in the light transmitting layer.

5. The semiconductor device according to claim 1, further comprising:
a second rewiring layer formed on the second surface side of the mold portion; and
a connection portion that is formed in the mold portion and electrically connects the rewiring layer and the second rewiring layer.

6. The semiconductor device according to claim 1, further comprising:
a second rewiring layer formed inside the mold portion; and
a connection portion that is formed in the mold portion and electrically connects the rewiring layer and the second rewiring layer.

7. The semiconductor device according to claim 1, wherein
the mold portion is formed to be flush with a front surface of the light transmitting layer on the first surface side, and
the rewiring layer is arranged on the outer side, in the planar direction, of the mold portion on the first surface side of the semiconductor substrate.

8. The semiconductor device according to claim 7, wherein
the wiring portion electrically connects the electrode and a wiring layer closest to the second surface side in the rewiring layer.

9. The semiconductor device according to claim 1, wherein
the light transmitting layer is formed to cover the semiconductor substrate and the first surface side of the rewiring layer.

10. The semiconductor device according to claim 9, further comprising
a second through hole provided at a position facing the rewiring layer in the light transmitting layer, wherein
the wiring portion electrically connects the electrode and the rewiring layer via the through hole and the second through hole.

11. The semiconductor device according to claim 1, wherein
the semiconductor substrate is an imaging element in which a plurality of pixels that convert incident light into an electric signal is arranged in a two-dimensional matrix, for example.

12. A manufacturing method of a semiconductor device, comprising:
forming a light transmitting layer that transmits light having a predetermined wavelength on a side of a first surface of a semiconductor substrate;
forming a through hole at a position facing an electrode of the semiconductor substrate in the light transmitting layer;
arranging a rewiring layer on a temporary substrate and arranging the semiconductor substrate and the light transmitting layer in a face-down manner;
integrating the semiconductor substrate, the light transmitting layer, and the rewiring layer by a mold portion;
separating the integrated semiconductor substrate, the light transmitting layer, the rewiring layer, and the mold portion from the temporary substrate; and
connecting the electrode of the semiconductor substrate and the rewiring layer by a wiring portion.
